(19) Europäisches Patentamt / European Patent Office / Office européen des brevets

(11) **EP 4 144 895 A1**

(12) **EUROPEAN PATENT APPLICATION**
published in accordance with Art. 153(4) EPC

(43) Date of publication:
**08.03.2023 Bulletin 2023/10**

(21) Application number: **20938587.1**

(22) Date of filing: **02.06.2020**

(51) International Patent Classification (IPC):
*C30B 23/00* $^{(2006.01)}$    *C30B 29/36* $^{(2006.01)}$
*C30B 35/00* $^{(2006.01)}$    *H01L 21/02* $^{(2006.01)}$

(52) Cooperative Patent Classification (CPC):
**C30B 23/00; C30B 29/36; C30B 35/00; H01L 21/02**

(86) International application number:
**PCT/KR2020/007157**

(87) International publication number:
**WO 2021/246542 (09.12.2021 Gazette 2021/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: SENIC Inc.
**Seobuk-gu**
**Cheonan-si, Chungcheongnam-do 31040 (KR)**

(72) Inventors:
• **PARK, Jonghwi**
  **Cheonan-si, Chungcheongnam-do 31040 (KR)**

• **CHOI, Jungwoo**
  **Cheonan-si, Chungcheongnam-do 31040 (KR)**
• **KIM, Junggyu**
  **Cheonan-si, Chungcheongnam-do 31040 (KR)**
• **KU, Kapryeol**
  **Cheonan-si, Chungcheongnam-do 31040 (KR)**
• **KYUN, Myungok**
  **Cheonan-si, Chungcheongnam-do 31040 (KR)**

(74) Representative: BCKIP Part mbB
**Siegfriedstraße 8**
**80803 München (DE)**

(54) **SILICON CARBIDE INGOT MANUFACTURING METHOD, SILICON CARBIDE INGOTS, AND GROWTH SYSTEM THEREFOR**

(57)    In a method for manufacturing a silicon carbide ingot, a silicon carbide ingot, a system for manufacturing a silicon carbide into according to embodiments of the present invention, a crucible assembly comprising a crucible body having an inner space and a crucible cover covering the crucible body, a silicon carbide ingot is grown after disposing a raw material and a silicon carbide seed, wherein a weight of the crucible assembly is set to have a weight ratio of 1.5 to 2.7 when a weight of the raw material is regarded as 1. Thus, a silicon carbide ingot has a large area and reduced defects can be manufactured.

[FIG. 2]

EP 4 144 895 A1

## Description

### Technical Field

Example embodiments disclosed in the specification relate to a method for manufacturing silicon carbide ingot, a silicon carbide ingot and a method for growing a silicon carbide ingot.

### Background Art

A single crystal of silicon carbide (SiC), silicon (Si), gallium nitride (GaN), sapphire ($Al_2O_3$), gallium arsenide (GaAs), aluminum nitride (AIN), or the like has characteristics that cannot be expected from a polycrystal counterpart thereof. Thus, a demand therefor in the industries is increasing.

In particular, single crystal silicon carbide (SiC) has a large energy band gap and is excellent in maximum break field voltage and thermal conductivity as compared with silicon (Si). In addition, the carrier mobility of single crystal silicon carbide is comparable to that of silicon, and the saturation drift rate of electrons and the breakdown voltage thereof are large as well. By virtue of such characteristics, single crystal silicon carbide is expected to be applied to semiconductor devices that require high efficiency, high breakdown voltage, and large capacity.

As for a method of growing a silicon carbide, liquid phase epitaxy (LPE), chemical vapor deposition (CVD), and physical vapor transport (PVT) are present. Among them physical vapor transport (PVT) has a high growth rate to grow a silicon carbide of an ingot type, so it is widely used and is also referred to as a seed-type sublimation method.

As a method for preparing such a single crystal, for example, Japanese Laid-open Patent Publication No. 2001-114599 discloses a method of growing a single crystal ingot on a seed crystal by maintaining the seed crystal at a temperature lower than that of a raw material powder by 10 to 100°C while heating it with a heater in a vacuum container (or a heating furnace) capable of introducing argon gas. In addition to this, there are attempts to manufacture a large-diameter single crystal ingot substantially without detects.

As a prior art, there are Korean Patent Publication No. 10-2012-0139398, Korean Patent Publication No. 10-2017-0041223 or the like.

### Disclosure of Invention

### Technical Problem

An object of example embodiments is to provide a silicon carbide ingot of a good quality, a method for manufacturing the same, a system for manufacturing a silicon carbide ingot or the like.

### Solution to Problem

In order to achieve the above object, a method for manufacturing a silicon carbide ingot according to an embodiment includes a preparation step of preparing a crucible assembly including a crucible body having an inner space and a crucible cover covering the crucible body; a raw material disposing step of disposing a raw material into the crucible assembly and disposing a silicon carbide seed at a predetermined distance from the raw material; and a growth step of adjusting the inner space of the crucible body to a crystal growth atmosphere so that the raw material is vapor-transferred to be deposited on the silicon carbide seed and preparing a silicon carbide ingot grown from the silicon carbide seed.

The crucible assembly has a weight ratio Rw such that the weight of the crucible assembly is 1.5 to 2.7 times of the weight of the raw material when the weight of the raw material is regarded as 1.

The crucible assembly has a length ratio Rl, which is a ratio of a length from the bottom surface where the raw material is located to the surface of the silicon carbide seed, is more than 1 time and 2.5 times or less when the diameter of the inner space of the crucible body is regarded as 1.

The crucible assembly may satisfy the condition that the weight-length coefficient Cwl according to Equation 1 below is 0.6 to 2.2.

[Equation 1]

$$C_{wl} = \frac{R_w}{R_l{}^2}$$

where the Cwl is a weight-length coefficient, Rw is a weight ratio and the Rl is a length ratio.

The pit of the surface of the silicon carbide ingot may be 10k/cm$^2$ or less.

A wafer in which an off angle of the silicon carbide ingot of 0 degree is applied may have a rocking angle of -1.0 to +1.0 degrees compared to a reference angle.

The silicon carbide ingot may be a large-diameter silicon carbide ingot of 4 inches or more.

A method for manufacturing a silicon carbide wafer according to another embodiment comprises: a preparation step of preparing a crucible assembly including a crucible body having an inner space and a crucible cover covering the crucible body; a raw material disposing step of disposing a raw material into the crucible assembly and disposing a silicon carbide seed at a predetermined distance from the raw material; a growth step of adjusting the inner space of the crucible body to a crystal growth atmosphere so that the raw material is vapor-transferred to be deposited on the silicon carbide seed and preparing a silicon carbide ingot grown from the silicon carbide seed; a slicing step of slicing the silicon carbide ingot to prepare a sliced crystal; and a polishing step of polishing the sliced crystal to form a silicon carbide wafer. The crucible assembly has a weight ratio Rw of 1.5 to 2.7 times the weight of the crucible assembly when the weight of the raw material is regarded as 1.

The slicing step may be a step of preparing the sliced crystal such that an off angle is an angle selected from 0 to 15 degrees.

The polishing step is a step of polishing such that a thickness of the silicon carbide wafer becomes 300 to 800 um.

The silicon carbide wafer is one in which an off angle of 0 to 15 degrees is applied and has a rocking angle of -1.0 to +1.0 degrees compared to a reference angle.

The silicon carbide ingot according to yet another embodiment has a large diameter of 4 inches or more and a surface of thereof has a pit of 10k/cm$^2$ or less.

The wafer in which an off angle of the silicon carbide ingot is applied as 0 degree may include a rocking angle of -1.0 to +1.0 degrees compared to a reference angle.

A system for growing a silicon carbide ingot according to an embodiment is a system comprising a reaction vessel and a heat and growing a silicon carbide ingot, wherein a crucible assembly comprising a crucible body having an inner space and a crucible cover covering the crucible body is disposed in the reaction vessel, wherein a raw material is disposed into the crucible assembly, and a silicon carbide seed is disposed at a predetermined distance from the raw material, wherein the heater induces the inner space to be in a crystal growth atmosphere so that the raw material is vapor-transferred and deposited on the silicon carbide seed and the silicon carbide ingot grown from the silicon carbide seed is prepared, and wherein the crucible assembly before the heating has a weight ratio Rw of 1.5 to 2.7 times the weight of the crucible assembly when the weight of the raw material is regarded as 1.

The crucible assembly may have a length ratio Rl, which is a ratio of a length from the bottom surface where the raw material is located to the surface of the silicon carbide seed, is more than 1 time and 2.5 times or less when a diameter of the inner space of the crucible body is regarded as 1.

The crucible assembly may have a weight-length coefficient Cwl according to Equation 1 below is 0.6 to 2.2.

[Equation 1]

$$C_{wl} = \frac{R_w}{R_l{}^2}$$

where the Cwl is a weight-length coefficient, Rw is a weight ratio and the Rl is a length ratio.

The silicon carbide ingot may be a large-diameter silicon carbide ingot of 4 inches or more.

A wafer in which an off angle of the silicon carbide ingot of 0 degree is applied may have a rocking angle of -1.0 to +1.0 degrees compared to a reference angle.

**Advantageous Effects of Invention**

A method of manufacturing a silicon carbide ingot according to an embodiment, a silicon carbine ingot, a system for growing the same or the like can provide a system for growing a silicon carbide ingot of good characteristics, a silicon carbide ingot, a wafer manufactured thereby, or the like.

**Brief Description of Drawings**

FIG. 1 is a conceptual view illustrating a reaction chamber according to one embodiment in a section view.

FIG. 2 and FIG. 3 are respectively a conceptual view illustrating a crucible assembly according to embodiments in a section view.

FIG. 4 shows a graph of temperature-pressure applied in an embodiment.

## Detailed Description for Carrying out Invention

Hereinafter, example embodiments of the present disclosure will be described in detail with reference to the accompanying drawings so that they can be easily practiced by those skilled in the art to which the present invention pertains. The example embodiments may, however, be embodied in many different forms and is not to be construed as being limited to the embodiments set forth herein. Like reference numerals designate like elements throughout the specification.

Throughout this application, the phrase that a certain element "comprises" or "includes" another element means that the certain element may further include one or more other elements but does not preclude the presence or addition of one or more other elements, unless stated to the contrary.

Throughout this application, it will be understood that when an element is referred to as being "connected" to another element, it can be directly connected to the other element or intervening elements may be present.

In this application, "B being placed on A" means that B is placed in direct contact with A or placed over A with another layer or structure interposed therebetween and thus should not be interpreted as being limited to B being placed in direct contact with A, unless the description clearly dictates.

In this application, the phrase "combination(s) thereof" included in a Markush-type expression denotes one or more mixtures or combinations selected from the group consisting of components stated in the Markush-type expression, that is, denotes that one or more components selected from the group consisting of the components are included.

In this application, the description "A and/or B" means "A or B, or A and B."

In this application, terms such as "first," "second," "A," or "B" are used to distinguish the same terms from each other. The singular forms "a," "an," and "the" include the plural form unless the context clearly dictates otherwise.

In this application, a singular form is contextually interpreted as including a plural form as well as a singular form unless specially stated otherwise.

In this specification, a length, an angle or the like in the drawings may be exaggeratedly expressed, and the embodiments are not limited and interpreted according to the shapes of the drawings unless there are special circumstances.

In this specification, in a measurement of surface pit of the silicon carbide ingot, at total five places, i.e., one place in a center of a surface of an ingot excluding a facet and four places corresponding to 3 o'clock, 6 o'clock, and 9 o'clock and 12 o'clock located about 10 mm inwardly from the edge of the silicon carbide ingot in the direction of the center, pits per unit area are respectively measured with an optical microscope and an evaluation is made with an average of five values.

In this specification, mentioning an off angle is X ° means having an off angle evaluated as X ° within the margin of error generally permitted, and for example, comprises an off angle in a range of (X ° - 0.05 °) to (X ° + 0.05 °). In case of 4H SiC, (0001) surface can be used as a reference surface.

In this specification, mentioning a rocking angle is "-1 ° to 1 °" compared to a reference angle, even if there is no special mention.

In this specification, mentioning a rocking angle is "-1 ° to 1 ° compared to a reference angle" means that a full width at half maximum (FWHM) value is within a range of (peak angle - 1 °) to (peak angle + 1 °) based on the peak angle as a reference angle.

Hereinafter, embodiments will be described in more detail.

The inventors have conducted research on a method of manufacturing a silicon carbide ingot having a large diameter and reduced defects, and the inventors have verified that a silicon carbide ingot having a large diameter and reduced defects can be manufactured by regulating ratios of a crucible and raw materials, a ratio of a width and a height of an inner space of a crucible, or the like, together with a temperature control, while growing a silicon carbide by applying a physical vapor transport (PVT), and have completed embodiments.

In order to achieve the above-mentioned object, a method for manufacturing a silicon carbide ingot 100 according to an embodiment includes a preparation step, a raw material disposing step and a growing step.

In the preparation step, a crucible assembly 200 including a crucible body 210 with an inner space and a cover 220 covering the crucible body.

In the raw material disposing step, a raw material 300 is disposed in the crucible assembly 200 and a silicon carbide seed 110 is disposed with predetermined distance from the raw material above the raw material.

The crucible body 210 may have a cylindrical shape with an open portion provided at an upper side and may have a structure in which a silicon carbide raw material can be disposed.

The crucible body 210 may have a density of 1.72 to 1.92 g/cm$^3$. The material of the crucible body 210 may include a graphite.

The crucible cover 220 may have a density of 1.72 to 1.92 g/cm$^3$. The material of the crucible body 210 may include a graphite.

The crucible cover 220 may have a shape of covering the entire opening of the crucible body 210. The crucible cover 220 may cover a portion of the opening of the crucible body 210 or include a through hole (not shown). In this case, it is possible to adjust the rate of vapor transport in the crystal growth atmosphere described later.

The silicon carbide seed may be disposed above the raw material by a method such as directly adhering to the crucible cover. In this case, a separate seed holder 230 is not applied, and the crucible cover 220 may be integrally applied with the seed holder.

The seed holder 230 may be applied separately from the crucible cover. Specifically, the seed holder 230 may be disposed at a predetermined position between the crucible body and the crucible cover or close to the opening of the crucible body in a configuration such as a locking groove to support the silicon carbide seed 110.

The crucible assembly 200 is assembled by combining the crucible body 210 and the crucible cover 220, and if necessary, the seed holder 230 is placed between the crucible body, the crucible cover, or therebetween, and subsequently, they can be assembled.

The raw material 300 includes a carbon source and a silicon source. Specifically, the raw material 300 may include a carbon-silicon source or may further include a carbon source and/or a silicon source. As the carbon source, a high carbon resin (e.g., phenolic resin) may be applied, and as the silicon source, silicon particles may be applied, but is not limited thereto. More specifically, as the raw material, silicon carbide particles may be applied.

The raw material 300 may contain particles having a particle size of 75 μm or less in an amount of 15% by weight or less, 10% by weight or less, or 5% by weight or less based on the total weight of the raw material. In this way, when a raw material having a relatively small content of small particle size is applied, the occurrence of defects in the ingot can be reduced and the control of supersaturation can be more advantageously performed, and the silicon carbide ingot that can provide a wafer having improved crystal characteristics can be manufactured.

The raw material 300 may be a raw material in the form of particles having a particle diameter (D$_{50}$) of 130 to 400 um, and the raw material in the form of particles may be necked or non-necked. When a raw material having such a particle size is applied, it is possible to produce a silicon carbide ingot providing wafers with better crystal properties.

In the raw material disposing step, the crucible assembly 200 may have a weight ratio (Rw) such that the weight of the crucible assembly is 1.5 to 2.7 times when the weight of the raw material 300 is regarded as 1. Here, the weight of the crucible assembly means the weight of the crucible assembly excluding raw materials, and specifically, regardless of whether or not the seed holder is applied to the crucible assembly, the weight is a value in which the weight of the raw material is excluded from the assembled crucible assembly including silicon carbide seeds.

If the weight ratio is less than 1.5, supersaturation increases excessively in the crystal growth atmosphere, so that the crystal quality of the ingot may rather deteriorate. If the weight ratio is greater than 2.7, supersaturation is lowered and thus crystal quality of the ingot may be deteriorated.

The weight ratio may be 1.6 to 2.6 and may be 1.7 to 2.4. In the case of having such a weight ratio, it is possible to manufacture an ingot having excellent defect characteristics or crystallinity characteristics.

The crucible assembly 200 has a length ratio Rl, which is a ratio of a length from the bottom surface where the raw material 300 is located to the surface of the silicon carbide seed 110 when the diameter Tw of the inner space of the crucible body 210 is 1, may be more than 1 time and 2.5 times or less. The length ratio Rl may be specifically greater than 1.1 times and less than 2 times and may be 1.2 to 1.8 times. When the crucible assembly having these characteristics is applied to the growth of the silicon carbide ingot of the present specification, the possibility of polymorphism due to supersaturation in a crystal growth atmosphere can be significantly reduced and an ingot of higher quality can be obtained.

The surface of the silicon carbide seed referred to in relation to the length ratio Rl means the surface (growth surface) of the silicon carbide seed, which is a surface on which crystals grow while facing the raw material, and it means the average value when the surface of the silicon carbide seed is arranged not to be parallel with the raw material.

The crucible assembly may satisfy the condition that the weight-length coefficient Cwl according to Equation 1 below is 0.6 to 2.2.

[Equation 1]

$$C_{wl} = \frac{R_w}{R_l{}^2}$$

where the Cwl is a weight-length coefficient, Rw is a weight ratio and the Rl is a length ratio.

Specifically, the weight-length coefficient Cwl may be 0.8 to 2.0. More specifically, the weight-length coefficient Cwl may be 0.9 to 1.85 and may be 1.0 to 1.80.

When a crucible assembly having such a weight-length coefficient value or a manufacturing method using the crucible assembly is applied, it is possible to grow a silicon carbide ingot having excellent crystallinity evaluated by a rocking angle and a pit value of the ingot surface.

The growing step is a step of adjusting the inner space of the crucible body 210 to a crystal growth atmosphere so that the raw material is vapor-transferred to be deposited on the silicon carbide seed and preparing a silicon carbide ingot grown from the silicon carbide seed.

The growing step includes a process of adjusting the inner space of the crucible assembly to a crystal growth atmosphere, and specifically can be performed by wrapping the crucible assembly 200 with an insulating material 400, the reaction vessel (not shown) including the crucible assembly and the insulating material surrounding it may be prepared, placing it in a reaction chamber such as a quartz tube, and then heating the crucible or the like by a heating means.

The reaction vessel is located in the reaction chamber 420 and the heating means 500 induces the inner space of the crucible body 210 to a temperature suitable for the crystal growth atmosphere. This temperature is one of the important factors in the crystal growth atmosphere, and a more suitable crystal growth atmosphere is formed by adjusting conditions such as pressure and gas movement. An insulator 400 is positioned between the reaction chamber 420 and the reaction vessel to facilitate the formation and control of a crystal growth atmosphere.

The heat insulating material 400 may affect a temperature gradient inside the crucible body or inside the reaction vessel in a growth atmosphere. Specifically, the heat insulating material may include a graphite insulating material, and more specifically, may include the heat insulating material may include a rayon-based graphite felt or a pitch-based graphite felt.

The heat insulating material 400 may have a density of 0.14 to 0.28 g/cc. The insulating material may have a porocity of 72 to 90 %. By applying such a heat insulating material, it is possible to suppress growth of a concave or excessively convex shape of an ingot, and it is possible to reduce a phenomenon in which polymorphic quality is degraded or cracks occur in an ingot.

The crystal growth atmosphere may be proceeded through heating of the heating means 500 outside the reaction chamber 420, and may be proceeded by removing air by reducing the pressure simultaneously with or separately from the heating, and in a reduced pressure atmosphere and/or an inert atmosphere (e.g., Ar atmosphere, $N_2$ atmosphere or a mixture thereof).

The crystal growth atmosphere induces the growth of silicon carbide crystal by vapor-transferring the raw material to the surface of the silicon carbide seed to grow into the ingot 100.

The crystal growth atmosphere may be subjected to a growth temperature of 2000 to 2500 ° C and a growth pressure of 1 to 200 torr, and silicon carbide ingots can be manufactured more efficiently when these temperatures and pressures are applied.

Specifically, the crystal growth atmosphere may be subjected to a growth temperature of 2100 to 2500 ° C, which is a temperature of an upper and lower surface of the crucible, and a growth pressure of 1 to 50 torr, and more specifically, to a growth temperature of 2150 to 2450 ° C and a growth pressure condition of 1 to 40 torr.

More specifically, conditions of a growth temperature of 2150 to 2350 ° C, which is a temperature of an upper and lower surface of the crucible, and a growth pressure of 1 to 30 torr may be applied.

If the crystal growth atmosphere described above is applied, it is more advantageous to manufacture a higher quality silicon carbide ingot.

The silicon carbide seed 110 may be applied differently depending on the characteristics of the ingot to be grown, and for example, 4H-SiC, 6H-SiC, 3C-SiC, 15R-SiC, etc. may be applied, but is not limited thereto.

The silicon carbide seed 110 may be applied differently depending on the size of the ingot to be grown, and the ingot may have a diameter of 4 inches or more, and specifically, the ingot may have a diameter of 4 inches or more, 5 inches or more, or 6 inches or more. More specifically, the ingot may have a diameter of 4 to 12 inches, 4 to 10 inches, or 4 to 8 inches.

The silicon carbide seed 110 is preferably applicable as long as it can grow single-crystal 4H-SiC, and exemplarily, a 4H-SiC seed in which a front surface on which a silicon carbide grows is a C-plane (0001) can be applied.

The raw material 300 is vapor-transported in a crystal growth atmosphere to move toward the silicon carbide seed and grows a silicon carbide ingot on the surface of the silicon carbide seed.

The silicon carbide ingot 100 contains 4H SiC and may have a convex or flat surface.

When the surface of the silicon carbide ingot 100 is formed in a concave shape, other polytypes such as 6H-SiC may be possibly mixed in addition to the intended 4H-SiC crystal, which may degrade the quality of the silicon carbide ingot. In addition, when the surface of the silicon carbide ingot is formed in an excessively convex shape, cracks may occur in the ingot itself, or crystals may be broken when processed into wafers.

At this time, whether the silicon carbide ingot 100 is an excessively convex ingot is determined based on the degree of warpage, and the warpage of the silicon carbide ingot manufactured in the embodiment is 15 mm or less.

The warpage is determined by placing a sample of a silicon carbide ingot that is completely grown on a surface plate and measuring heights of the center and the edge of the ingot with a height gauge based on the rear surface of the ingot, thereby evaluating it as a value of a difference between the center height and the edge height. A positive value of warpage means convexity, a value of 0 means flatness, and a negative value means concaveness.

Specifically, the silicon carbide ingot 100 may have a convex or flat surface, and may have a warpage of 0 to 15 mm, 0 to 12 mm, or 0 to 10 mm. A silicon carbide ingot having such a degree of warpage is easier to process a wafer and can reduce the occurrence of cracks.

The silicon carbide ingot 100 may be a substantially single crystal 4H SiC ingot in which detects or polytype inclusion are minimized.

The silicon carbide ingot 100 is substantially made of 4H SiC, and its surface may be convex or flat.

The silicon carbide ingot 100 has reduced defects that may occur in the silicon carbide ingot and can provide a higher quality silicon carbide wafer.

The silicon carbide ingot manufactured by the method of embodiments reduces pits on the surface thereof, and specifically, in an ingot having a diameter of 4 inches or more, the pit included in the surface is 10k/cm$^2$ or less.

In an embodiment, in a measurement of surface pit of the silicon carbide ingot, at total five places, i.e., one place in a center of a surface of an ingot excluding a facet and four places corresponding to 3 o'clock, 6 o'clock, and 9 o'clock and 12 o'clock located about 10 mm inwardly from the edge of the silicon carbide ingot in the direction of the center, pits per unit area are respectively measured with an optical microscope and an evaluation is made with an average of five values.

The silicon carbide ingot can be processed into a silicon carbide wafer in a conventional manner.

Exemplarily, after applying external grinding equipment to the silicon carbide ingot to trim the outer rim of the ingot (External Grinding) and cutting to a certain thickness (Slicing), processing such as edge grinding, surface polishing, polishing or the like may be performed.

Specifically, a wafer obtained from an ingot in which an off angle of 0 degree relative (0001) surface is applied may have a rocking angle of -1.0 to +1.0 degrees compared to a reference angle, -0.5 to +0.5 degrees compared to a reference angle, and -0.05 to +0.05 degrees compared to a reference angle. An ingot having these characteristics have excellent crystalline properties.

The rocking angle is set by applying a high-resolution X-ray diffraction analysis system (HR-XRD system) to evaluate crystallinity according to a following method. The direction of the wafer [11-20] is fitted to an X-ray route, the angles of X-ray source optic and X-ray detector optic are set to be 2$\theta$ (35° to 36°), and thereafter omega ($\omega$, or $\theta$ as an X-ray detector optic) angle is adjusted to be fitted with an off angle of a wafer for measuring a rocking curve, wherein the difference values between a peak angle as a reference angle and two full width at half maximum (FWHM) values are respectively set as rocking angles to evaluate crystallinity(hereinafter, the same applies to the rocking angle).

In this application, mentioning an off angle is X° means having an off angle evaluated as X° within the margin of error generally permitted, and for example, comprises an off angle in a range of (X° - 0.05°) to (X° + 0.05°).

In embodiments, mentioning a rocking angle is "-1° to 1° compared to a reference angle" means that a full width at half maximum (FWHM) value is within a range of (peak angle - 1°) to (peak angle + 1°) based on the peak angle as a reference angle.

Moreover, for the rocking angle, a surface excepting for the center and portions within 5 mm from the edges to the center is trisected to be substantially equal, and the result of measuring three times or more in respective portions was averaged to be treated as the above rocking angle.

In detail, when the off angle is 0°, the omega angle is 17.8111°, when the off angle is 4°, the omega angle is 13.811°, and when the off angle is 8°, the omega angle is 9.8111°. Thus, the omega angle is in a range of 9.8111 to 17.8111.

Specifically, a wafer obtained from the ingot in which an off angle of 4 degrees is applied may have a rocking angle of -1.5 to +1.5 degrees compared to a reference angle, -1.0 to +1.0 degrees compared to a reference angle, -0.5 to +0.5 degrees compared to a reference angle, -0.1 to +0.1 degrees compared to a reference angle, and -0.05 to +0.05 degrees compared to a reference angle. An ingot having these characteristics have excellent crystalline properties.

Specifically, a wafer obtained from the ingot in which an off angle of 8 degrees is applied may have a rocking angle of -1.0 to +1.0 degrees compared to a reference angle, -0.5 to +0.5 degrees compared to a reference angle, -0.1 to +0.1 degrees compared to a reference angle, and -0.05 to +0.05 degrees compared to a reference angle. An ingot having these characteristics have excellent crystalline properties.

The silicon carbide ingot may be a large-diameter silicon carbide ingot of 4 inches or more. The ingot may have a diameter of 4 inches or more, 5 inches or more, or 6 inches or more. More specifically, the ingot may have a diameter of 4 to 12 inches, 4 to 10 inches, or 4 to 8 inches. According to the embodiments disclosed herein, a silicon carbide ingot having a relatively large diameter and having excellent crystal quality and low defect characteristics as described above can be manufactured.

A method of manufacturing a silicon carbide wafer according to another embodiment includes a slicing step of slicing a silicon carbide ingot prepared by processes comprising a preparation step and a growth step; and a polishing step, and thereby manufactures a silicon carbide wafer. Features and detailed descriptions of each step of the preparation step, the raw material disposing step, the growth step, the raw material, the crucible body, the crucible cover, the crucible assembly, the silicon carbide seed or the like are the same with the above description, so the detailed description thereof will be omitted.

The slicing step is a step of preparing a sliced crystal by slicing a silicon carbide ingot to have a constant off angle. An off angle is based on a (0001) plane in 4H SiC. Specifically, the off angle may be an angle selected from 0 to 15 degrees, may be an angle selected from 0 to 12 degrees, or may be an angle selected from 0 to 8 degrees.

The slicing may be a slicing method that can be applied to a normal wafer manufacturing, and exemplarily, a slicing using a diamond wire or a wire to which diamond slurry is applied, a slicing using a blade or wheel to which diamond is partially applied, etc. can be applied, but is limited to these.

The thickness of the sliced crystal may be adjusted in consideration of the thickness of the wafer to be manufactured, and may be sliced to an appropriate thickness in consideration of the thickness after polishing in the polishing step to be described later.

The polishing step is a step of forming a silicon carbide wafer by polishing the sliced crystal to a thickness of 300 to 800 um.

In the polishing step, a polishing method commonly applied to wafer manufacturing may be applied, and exemplarily, a method in which a process such as lapping and/or grinding is performed and polishing is subsequently performed may be applied.

A silicon carbide wafer manufactured in this way has a large diameter of 4 inches or more, contains 4H SiC, and applies an off angle of 0 degrees compared to a (0001) plane of 4H SiC and has a rocking angle of -1.0 to +1.0 compared to the reference angle. The silicon carbide wafer has a large diameter and has advantages of having substantially single crystal characteristics, low defects and excellent crystal characteristics.

A silicon carbide ingot according to another embodiment has a large diameter of 4 inches or more, contains 4H SiC, and has a pit of a surface is $10k/cm^2$ or less.

A wafer in which an off angle of a silicon carbide ingot is 0 degrees may have a rocking angle of -1.0 to +1.0 degrees compared to the reference angle. The off angle is based on the (0001) plane of 4H SiC. A silicon carbide ingot having such characteristics is excellent in crystal quality while having a large area.

A system for manufacturing a silicon carbide ingot according to another embodiment includes a reaction vessel and a reaction chamber 420 to grow a silicon carbide ingot.

In the reaction vessel, a crucible assembly 200 including a crucible body 210 having an inner space and a crucible cover 220 covering the crucible body is disposed, and raw materials are disposed in the crucible assembly and a silicon carbide seed is disposed at a predetermined distance from the raw material.

In the reaction vessel, as described above, the crucible assembly may be positioned in a state of being wrapped with a heat insulating material.

The reaction chamber 420 has the reaction vessel located therein and brings the crucible body or its inner space to a temperature suitable for the crystal growth atmosphere by a heating means. Along with this temperature control, a more suitable crystal growth atmosphere is formed by adjusting conditions such as pressure in the inner space and movement of gas.

A crystal growth atmosphere is created so that the raw material 300 is vapor-transferred and deposited in the inner space of the crucible body 210 and silicon carbide crystals grow on the growth surface of the silicon carbide seed 110.

In the system, the weight of the crucible assembly has a weight ratio of 1.5 to 2.7 times the weight of the raw material as 1. A detailed description of this weight ratio is omitted because it overlaps with the above description. In addition, detailed descriptions such as structures and characteristics of the crucible body 210, the crucible cover 220, the crucible assembly 200, the silicon carbide seed 110, the seed holder 230, the silicon carbide ingot 100, weight ratio, length ratio, weight-length coefficient, the silicon carbide ingot grown therein, the silicon carbide wafer are the same with the above description, so the description thereof is omitted.

Hereinafter, the present invention will be described in more detail through specific examples. The following embodiments are merely examples to aid understanding of the present invention, and the scope of the invention disclosed herein is not limited thereto.

**Growth of Silicon Carbide Ingot**

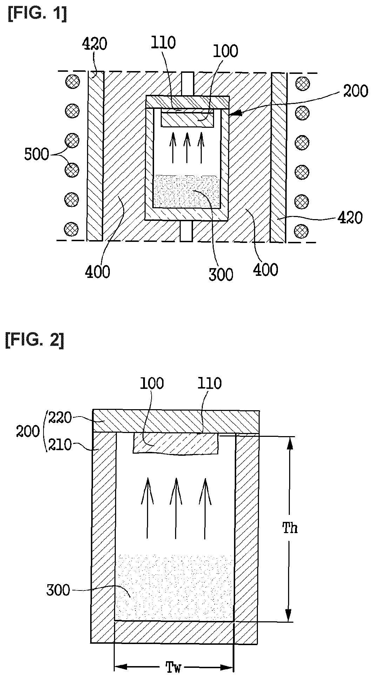

A silicon carbide ingot was manufactured by applying the crucible assembly having the structure shown in FIG. 2. Specifically, silicon carbide particles as a raw material were charged into the inner space of the crucible body, and a silicon carbide seed was placed thereabove. At this time, the silicon carbide seed was fixed by a conventional method such that the C surface (0001) of the silicon carbide seed (4H SiC single crystal, 6 inches) faced toward the bottom of the crucible, and the same was applied to the following Examples and Comparative Examples. The length ratio of the applied crucible assembly and the weight% of the raw material having a diameter of less than 75 $\mu$m in the silicon carbide particles applied as the raw material to the crucible (all silicon carbide particles being 100%) are shown in Table 1 below.

The crucible assembly was placed in a reaction chamber equipped with the same heat insulating material and equipped with a heating coil as a heating means.

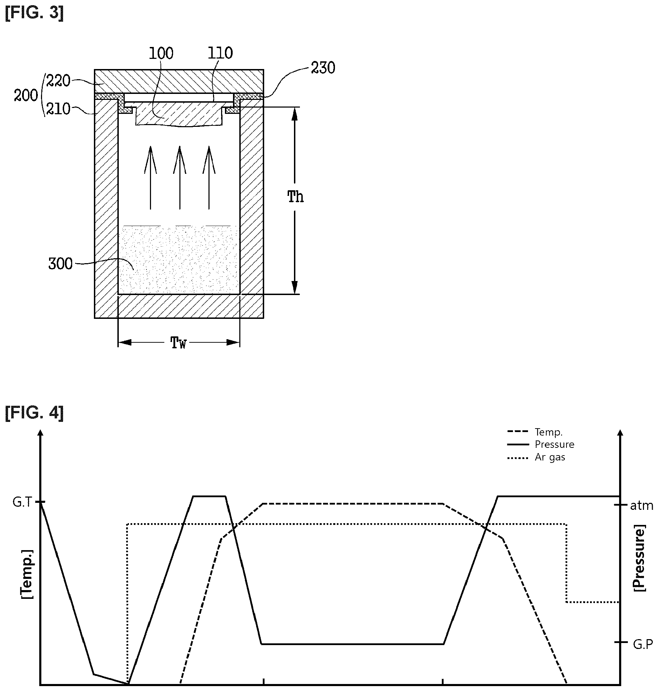

After making the inner space of the crucible assembly into a vacuum state, argon gas was slowly injected to reach the atmospheric pressure in the inner space of the crucible assembly, and then the inside of the crucible assembly was gradually depressurized again. At the same time, the temperature in the crucible assembly was gradually raised to 2300°C. A SiC single crystal ingot was grown for 100 hours at a temperature of 2300 °C and a pressure of 20 torr (see FIG. 4).

**Evaluations of physical properties of Silicon Carbide Ingot**

(1) Evaluation of Rocking Angle

A high-resolution X-ray diffraction analysis system (HR-XRD system, Rigaku's SmartLab High Resolution X-ray Diffraction System) was applied to prepare a wafer with an off angle of 0 degrees compared to a (0001) surface of 4H SiC from the ingot, and the [ 11-20] direction was set to the X-ray path, the angle of the X-ray source optic and the X-ray detector optic was set to 2θ (35 to 36 degrees), and the omega (ω, or theta θ, X-ray detector optic) angle was adjusted to the off angle of the wafer and was measured. Specifically, the omega angle was 17.8111 degrees at an off angle of 0 degrees. The X-ray power was 9kW, the X-ray target was Cu, and the Goniometer resolution was 0.0001 degree. The FWHM was measured based on the angle at Max Intensity and evaluated as a rocking angle, respectively, and the results are shown in Table 1.

The rocking angle results below were obtained by dividing the surface excluding the parts within 5 mm from the center and the edge of the wafer into three parts, measuring at least three times at each part and averaging the results of measurements.

(2) Evaluation of Pit Values

Pit value was measured at total five locations, i.e., one location in the center of the center portion excluding the facet and four locations of 10 mm from the edge of the ingot to the center portion and being at 3 o'clock, 6 o'clock, 9 o'clock, and 12 o'clock, respectively, and then the average value of the five pit values is presented as the pit value in the table below.

[Table 1]

| | Weight ratio* | Length ratio* | Weight-length coefficient* | wt% of raw materials with diameter less than 75um | Rocking angle* | Pit value (k/cm$^2$) |
|---|---|---|---|---|---|---|
| Example 1 | 1.7 | 1.3 | 1.01 | 15 | 17.811° ±0.09° | 8.5 |
| Example 2 | 2 | 1.2 | 1.39 | 13 | 17.811° ±0.09° | 9.2 |
| Example 3 | 2.1 | 1.1 | 1.74 | 10 | 17.811° ±0.07° | 9.3 |
| Example 4 | 2.2 | 1.1 | 1.82 | 5 | 17.811° ±0.10° | 8.9 |
| Example 5 | 2.3 | 1.1 | 1.90 | 6 | 17.811° ±0.08° | 9.9 |
| Example 6 | 2.5 | 1.9 | 0.69 | 10 | 17.811° ±0.10 | 9.4 |
| Comparative example 1 | 3 | 1 | 3.00 | 30 | 17.811° ± 1.7° | 12.3 |
| Comparative example 2 | 1 | 3 | 0.11 | 35 | 17.811° ± 1.7° | 11.6 |

(continued)

|  | Weight ratio* | Length ratio* | Weight-length coefficient* | wt% of raw materials with diameter less than 75um | Rocking angle* | Pit value (k/cm$^2$) |
|---|---|---|---|---|---|---|
| Comparative example 3 | 1.1 | 3.1 | 0.11 | 13 | 17.811°± 1.8 ° | 13.1 |

* The weight ratio refers to a weight ratio of the crucible assembly excluding the raw material when the weight of the raw material is regarded as 1.
* The length ratio refers to a ratio of a length Th from the bottom surface where the raw material is located to the surface of the silicon carbide seed when the diameter Tw of the inner space of the crucible body is regarded as 1.
* The weight-length factor is a value obtained by dividing the weight ratio by the square of the length ratio.
* This is the result measured on a sample to which Wafer Off angle was applied as 0 degrees.

Referring to Table 1, when the weight ratio is 1.5 to 2.7, the locking angle value is significantly smaller than the results outside the above range, such as 1 or 3, confirming that the crystal properties of the manufactured ingot are excellent. In addition, in the case of the length ratio, the result was excellent when the length ratio is more than 1 and less than 2.5.

In the embodiments in which the weight-length coefficient value was 0.6 to 2.2, the rocking angles and the pit values were excellent as a whole.

The weight percent wt% of the raw material with a diameter of less than 75um seems to have some effects on the crystal quality, and this is assumed because it can affect the supersaturation in the crystal growth atmosphere along with the weight ratio and the length ratio.

Although preferred embodiments of the present invention have been described in detail above, the scope of the present invention is not limited thereto, and various modifications and improvements by those skilled in the art using the basic concept of the present invention as defined in the following claims are also within the scope of the invention.

**Claims**

1.   A method for manufacturing a silicon carbide ingot comprising:

   a preparation step of preparing a crucible assembly including a crucible body having an inner space and a crucible cover covering the crucible body;
   a raw material disposing step of disposing a raw material into the crucible assembly and disposing a silicon carbide seed at a predetermined distance from the raw material; and
   a growth step of adjusting the inner space of the crucible body to a crystal growth atmosphere so that the raw material is vapor-transferred to be deposited on the silicon carbide seed and preparing a silicon carbide ingot grown from the silicon carbide seed,
   whererin the crucible assembly has a weight ratio Rw of 1.5 to 2.7 times the weight of the crucible assembly when the weight of the raw material is regarded as 1.

2.   The method for manufacturing a silicon carbide ingot of claim 1, wherein the crucible assembly has a length ratio Rl, which is a ratio of a length from the bottom surface where the raw material is located to the surface of the silicon carbide seed, is more than 1 time and 2.5 times or less when a diameter of the inner space of the crucible body is regarded as 1.

3.   The method for manufacturing a silicon carbide ingot of claim 2, wherein the crucible assembly has a weight-length coefficient Cwl according to Equation 1 below is 0.6 to 2.2.

[Equation 1]

$$C_{wl} = \frac{R_w}{R_l{}^2}$$

where the Cwl is a weight-length coefficient, Rw is a weight ratio and the Rl is a length ratio.

4. The method for manufacturing a silicon carbide ingot of claim 1, wherein a surface of the silicon carbide ingot has a pit of 10k/cm$^2$ or less.

5. The method for manufacturing a silicon carbide ingot of claim 1, wherein the silicon carbide ingot is a large-diameter silicon carbide ingot of 4 inches or more.

6. A method for manufacturing a silicon carbide wafer comprising:

   a preparation step of preparing a crucible assembly including a crucible body having an inner space and a crucible cover covering the crucible body;
   a raw material disposing step of disposing a raw material into the crucible assembly and disposing a silicon carbide seed at a predetermined distance from the raw material;
   a growth step of adjusting the inner space of the crucible body to a crystal growth atmosphere so that the raw material is vapor-transferred to be deposited on the silicon carbide seed and preparing a silicon carbide ingot grown from the silicon carbide seed;
   a slicing step of slicing the silicon carbide ingot to prepare a sliced crystal; and
   a polishing step of polishing the sliced crystal to form a silicon carbide wafer,
   wherein the crucible assembly has a weight ratio Rw of 1.5 to 2.7 times the weight of the crucible assembly when the weight of the raw material is regarded as 1.

7. The method for manufacturing a silicon carbide wafer of claim 6, wherein the slicing step is a step of preparing the sliced crystal such that an off angle is an angle selected from 0 to 15 degrees, and wherein the silicon carbide wafer has a rocking angle of -1.0 to +1.0 degrees compared to a reference angle.

8. The method for manufacturing a silicon carbide wafer of claim 6, wherein the polishing step is a step of polishing so that the thickness of the silicon carbide wafer is 300 to 800 um, a method for manufacturing a silicon carbide wafer.

9. A system for growing a silicon carbide ingot and comprising a reaction vessel and a heat, wherein a crucible assembly comprising a crucible body having an inner space and a crucible cover covering the crucible body is disposed in the reaction vessel, wherein a raw material is disposed into the crucible assembly, and a silicon carbide seed is disposed at a predetermined distance from the raw material, wherein the heater induces the inner space to be in a crystal growth atmosphere so that the raw material is vapor-transferred and deposited on the silicon carbide seed and the silicon carbide ingot grown from the silicon carbide seed is prepared, and wherein the crucible assembly before the heating has a weight ratio Rw of 1.5 to 2.7 times the weight of the crucible assembly when the weight of the raw material is regarded as 1.

10. The system for growing a silicon carbide ingot of claim 9, wherein the crucible assembly has a length ratio Rl, which is a ratio of a length from the bottom surface where the raw material is located to the surface of the silicon carbide seed, is more than 1 time and 2.5 times or less when a diameter of the inner space of the crucible body is regarded as 1, and

   wherein the crucible assembly has a weight-length coefficient Cwl according to Equation 1 below is 0.6 to 2.2.

[Equation 1]

$$C_{wl} = \frac{R_w}{R_l{}^2}$$

where the Cwl is a weight-length coefficient, Rw is a weight ratio and the Rl is a length ratio.

[FIG. 1]

[FIG. 2]

[FIG. 3]

[FIG. 4]

<table>
<tr><td colspan="2" align="center">**INTERNATIONAL SEARCH REPORT**</td><td colspan="2">International application No.<br><br>**PCT/KR2020/007157**</td></tr>
<tr><td colspan="4">**A.    CLASSIFICATION OF SUBJECT MATTER**<br><br>**C30B 23/00**(2006.01)i; **C30B 29/36**(2006.01)i; **C30B 35/00**(2006.01)i; **H01L 21/02**(2006.01)i<br><br>According to International Patent Classification (IPC) or to both national classification and IPC</td></tr>
<tr><td colspan="4">**B.    FIELDS SEARCHED**</td></tr>
<tr><td colspan="4">Minimum documentation searched (classification system followed by classification symbols)<br><br>C30B 23/00(2006.01); C30B 15/10(2006.01); C30B 15/36(2006.01); C30B 23/02(2006.01); C30B 23/06(2006.01); C30B 27/02(2006.01); C30B 29/20(2006.01); C30B 29/36(2006.01)</td></tr>
<tr><td colspan="4">Documentation searched other than minimum documentation to the extent that such documents are included in the fields searched<br><br>Korean utility models and applications for utility models: IPC as above<br>Japanese utility models and applications for utility models: IPC as above</td></tr>
<tr><td colspan="4">Electronic data base consulted during the international search (name of data base and, where practicable, search terms used)<br><br>eKOMPASS (KIPO internal) & keywords: 탄화규소(siliconcarbide), 잉곳(ingot), 도가니(furnace), 웨이퍼(wafer), 중량비율 (weight ratio), 폭(width), 길이(length)</td></tr>
<tr><td colspan="4">**C.    DOCUMENTS CONSIDERED TO BE RELEVANT**</td></tr>
<tr><td>Category*</td><td colspan="2">Citation of document, with indication, where appropriate, of the relevant passages</td><td>Relevant to claim No.</td></tr>
<tr><td align="center">Y</td><td colspan="2">KR 10-2012-0024767 A (SUMITOMO ELECTRIC INDUSTRIES, LTD.) 14 March 2012 (2012-03-14)<br>    See paragraphs [0044], [0060]-[0064] and [0097]-[0102], and figure 2.</td><td align="center">1-10</td></tr>
<tr><td align="center">Y</td><td colspan="2">JP 2013-082629 A (SICRYSTAL AG) 09 May 2013 (2013-05-09)<br>    See paragraphs [0008], [0033] and [0034], and figure 1.</td><td align="center">1-10</td></tr>
<tr><td align="center">A</td><td colspan="2">JP 5650869 B1 (ALLIED MATERIAL CORP.) 07 January 2015 (2015-01-07)<br>    See entire document.</td><td align="center">1-10</td></tr>
<tr><td align="center">A</td><td colspan="2">JP 4178989 B2 (SUMITOMO METAL MINING CO., LTD.) 12 November 2008 (2008-11-12)<br>    See entire document.</td><td align="center">1-10</td></tr>
<tr><td align="center">E</td><td colspan="2">KR 10-2187449 B1 (SKC CO., LTD.) 11 December 2020 (2020-12-11)<br>    See claims 1, 5-10, 13, 16 and 17.</td><td align="center">1-10</td></tr>
<tr><td colspan="2">☐ Further documents are listed in the continuation of Box C.</td><td colspan="2">☑ See patent family annex.</td></tr>
<tr><td colspan="2">*    Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed</td><td colspan="2">"T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family</td></tr>
<tr><td colspan="2">Date of the actual completion of the international search<br><br>**18 February 2021**</td><td colspan="2">Date of mailing of the international search report<br><br>**24 February 2021**</td></tr>
<tr><td colspan="2">Name and mailing address of the ISA/KR<br><br>**Korean Intellectual Property Office**<br>**Government Complex-Daejeon Building 4, 189 Cheongsa-**<br>**ro, Seo-gu, Daejeon 35208**</td><td colspan="2">Authorized officer</td></tr>
<tr><td colspan="2">Facsimile No. **+82-42-481-8578**</td><td colspan="2">Telephone No.</td></tr>
</table>

Form PCT/ISA/210 (second sheet) (July 2019)

INTERNATIONAL SEARCH REPORT

Information on patent family members

International application No.

**PCT/KR2020/007157**

| Patent document cited in search report | | | Publication date (day/month/year) | Patent family member(s) | | | Publication date (day/month/year) |
|---|---|---|---|---|---|---|---|
| KR | 10-2012-0024767 | A | 14 March 2012 | CA | 2735975 | A1 | 18 November 2010 |
| | | | | CN | 102160143 | A | 17 August 2011 |
| | | | | EP | 2432000 | A1 | 21 March 2012 |
| | | | | JP | 5344037 | B2 | 20 November 2013 |
| | | | | KR | 10-2012-0011059 | A | 06 February 2012 |
| | | | | TW | 201101482 | A | 01 January 2011 |
| | | | | US | 2011-0165764 | A1 | 07 July 2011 |
| | | | | WO | 2010-131568 | A1 | 18 November 2010 |
| JP | 2013-082629 | A | 09 May 2013 | DE | 102010029755 | A1 | 08 December 2011 |
| | | | | JP | 2011-256096 | A | 22 December 2011 |
| JP | 5650869 | B1 | 07 January 2015 | WO | 2014-148156 | A1 | 25 September 2014 |
| JP | 4178989 | B2 | 12 November 2008 | JP | 2004-250248 | A | 09 September 2004 |
| KR | 10-2187449 | B1 | 11 December 2020 | | None | | |

Form PCT/ISA/210 (patent family annex) (July 2019)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001114599 A
- KR 1020120139398

- KR 1020170041223